# EUROPEAN PATENT APPLICATION

(11) **EP 4 531 201 A1**
(43) Date of publication of application: **02.04.2025**
(21) Application number: 23200651.0
(22) Date of filing: 28.09.2023
(51) Int. Cl.: H01P 1/218, H03H 2/00

(54) **FILTERING DEVICE AND PROCESS FOR FILTERING RADIOFREQUENCY SIGNALS**

(71) Applicant: Universität Wien, 1010 Vienna (AT); Brno University Of Technology, 60190 Brno (CZ)
(72) Inventor: CHUMAK, Andrii, 1090 Vienna (AT); WANG, Qi, 1090 Vienna (AT); DAVÍDKOVÁ, Kristýna, 1090 Vienna (AT); KORALTAN, Sabri, 1090 Vienna (AT); URBÁNEK, Michal, 612 00 Brno (CZ); SÜSS, Dieter, 1090 Vienna (AT)
(74) Representative: Ho, Dominik

(57) **Abstract**

The present invention pertains to a device and a process for filtering input radiofrequency signals (10), wherein a spin wave guiding means (3) is magnetized using a static magnetic field of a magnetization means (4), wherein a spin wave (30) is excited in the spin wave guiding means (3) by excitation means (1) using an input radiofrequency signal (10), wherein the spin waves (30) are guided by the spin wave guiding means (3) from the excitations means (1) to detection means (2), wherein the spin wave (30) is detected in the spin wave guiding means (3) by the detection means (2) and transformed into an output radiofrequency signal (20), wherein the input radiofrequency signal (10) is filtered by the excitation means (1) and/or by detection means (2) and/or by the spin wave guiding means (3) and/or by the magnetization means (4).

## Description

### Technical Field

The invention relates to a filtering device and a process for filtering radiofrequency signals.

### Technological Background

Fifth generation digital communication systems (5G) provide an improved broadband connectivity in a wireless mobile network compared to 4G digital communication systems. This advantage is based on the expansion of the frequency bands from 0.8GHz to 2.1 GHz in 4G to up to 26GHz in 5G. Therefore, radiofrequency filters are required, which are capable of filtering such high frequencies.

It is known from the prior art to utilize Surface Acoustic Wave (SAW) filters for filtering radiofrequency signals with low frequencies. A SAW filter comprises two interdigital transducers (IDTs), each consisting of a pair of comb-shaped interlocking electrodes, which are arranged on a piezoelectric substrate. By application of a radiofrequency signal to the IDTs, the IDTs periodically distort the underlying piezoelectric substrate, which results in the excitation acoustic surface waves on the piezoelectric substrate.

However, the realization of SAW filters for high frequencies is challenging, as the efficiency of IDTs drastically drops down as well as SAW damping increases what results in the increased insertion loss. Furthermore, the passband frequency of SAW filters is determined by the spatial dimensions of the IDTs, such that SAW filters for high frequencies cannot be produced with common photolithography.

### Summary of the invention

It is an object of the present invention to provide a device for filtering input radiofrequency signals. In a first aspect, a process for filtering input radiofrequency signals is suggested, wherein a spin wave guiding means is magnetized using a static magnetic field of a magnetization means, wherein a spin wave is excited in the spin wave guiding means by excitation means using an input radiofrequency signal, wherein the spin waves are guided by the spin wave guiding means from the excitations means to detection means, wherein the spin wave is detected in the spin wave guiding means by the detection means and transformed into an output radiofrequency signal, wherein the input radiofrequency signal is filtered by the excitation means and/or by detection means and/or by the spin wave guiding means and/or by the magnetization means.

Spin waves, and their quasi-particles known as magnons, are a collective excitation of the spins in a magnetic material which transport angular momentum along their propagation direction. The behaviour and properties of spin waves are governed by various parameters, such as the strength and direction of the static magnetic field and the geometry and material properties, in particular the saturation magnetization and the exchange stiffness of the spin wave guiding means.

From the strength and direction of the static magnetic field and the geometry and material properties of the spin wave guiding means, the so-called spin wave manifold is determined, which in general connects the available spin wave frequencies with the strength of the magnetic field and the orientation of the spin wave propagation relative to the direction of the magnetization.

Spin wave guiding means can be understood as a magnetic medium with a saturation magnetization, preferably with a rectangular shape, with a length, a width and a thickness.

Magnetization means can be understood as any source of a static magnetic field, which interacts with the magnetization of the spin wave guiding means. Preferably the magnetization means comprises a magnetic material with a magnetization, with a length, a width and a thickness, which provides a static magnetic field to the spin wave guiding means.

Preferably, the strength of the static magnetic field of the magnetization means can align the magnetization of the spin wave guiding means along the direction of the static magnetic field. For this, the strength of the static magnetic field can be stronger than the saturation magnetization. The strength of the static magnetic field can also be well below the saturation magnetization due to anisotropies in the spin wave guiding means or demagnetization effects in the spin wave guiding means, but still align the magnetization along the direction of the static magnetic field.

More preferably the static magnetic field is applied along the width axis of the spin wave guiding means, such that the magnetization is aligned along the width axis of the spin wave guiding means.

In some embodiments such a magnetic field might be realized or influenced by exchange bias fields. To increase the exchange bias effect in a spin wave waveguide, a magnetic multilayer can be used comprising several stacks of magnetic layer/antiferromagnetic layer. The exchange bias direction might furthermore be set be field cooling.

Excitation means can be understood as means which excite spin waves in the spin wave guiding means. Typically the excitation means provide an oscillating magnetic field perpendicular to the static magnetic field, i.e. to the aligned magnetization of the spin wave guiding means. In this way the magnetization can be periodically pushed away from its equilibrium position. In other words, the oscillating magnetic field of the excitation means can excite spin waves in the spin wave guiding means with the frequency of the oscillating magnetic field. The oscillating magnetic field is typically generated based on the input radiofrequency signal by the excitation means, where the input radiofrequency signal is an alternating current in the excitation means. The input radiofrequency signal has a certain amplitude and a frequency in the radiofrequency range. The frequency thereby has to match to the determined spin wave manifold, otherwise no spin wave can be excited.

In some embodiments the excitation means generate spin torques, such as spin transfer torque or spin orbit torque which excite the spin waves in the spin wave guiding means. For example, a spin torque originates, when the excitation means comprises or consist of heavy metals, where the excitation means are arranged on top or below the spin wave waveguide. A charge current through the excitation means can be transformed into a spin torque that acts on the magnetization of the spin wave waveguide. In order to increase the excitation efficiency using spin torques, multilayers can be used in the excitation means, comprising a natural number N stacks of non-magnetic layer 1/magnetic layers/non-magnetic layer 2-bilayers.

In some embodiments at least one of the non-magnetic layer is a heavy metal layer, such as Platinum, Tantalum, Palladium, Tungsten, that produces a spin orbit torque on the adjacent spin wave waveguide. The other non-magnetic layer might be an heavy metal layer, or a non-magnetic and non-conducting layer, such as MgO, AIO.

The spin waves propagate from the excitation means through the spin wave guiding means to the detection means. The spin waves can then be detected in the spin wave guiding means by detection means. The detection mechanism uses the reverse process of the excitation, also known as principle of reciprocity. Hereby, the spin waves generate an oscillating magnetic field, which generates an oscillating current in the detection means by electromagnetic induction. The current in the detection means is called the output radiofrequency signal.

In some embodiments the detection is realized by utilizing the inverse Spin Hall effect. For this, the detection means comprises or consists of heavy metals which is arranged on top or below to the spin wave waveguide. An oscillating magnetization in the spin wave waveguide then produces a spin current which is transferred in the heavy metal and transformed into a charge current, which can be measured with the detection means.

According to the invention, the input radiofrequency signal is filtered by the excitation means and/or by detection means and/or by the spin wave guiding means and/or by the magnetization means.

Filtering describes the process that the output radiofrequency signal is modified compared to the input radiofrequency signal.

Each of the filtering mechanism introduces a certain bandwidth, which limits the bandwidth of the output radiofrequency signal compared to the input radiofrequency signal. It is thus possible to reduce the bandwidth of the input radiofrequency signal by a proper alignment of excitation means, detection means, spin wave guiding means and magnetization means.

With the process disclosed above, it is possible to replace surface acoustic wave filtering by spin wave filtering. The radiofrequency signal is not transported by acoustic surface waves but by spin waves. Spin waves have the advantage that they are easily tunable by the static magnetic field and material properties of the spin wave guiding means. Spin waves further can have very small wavelengths down to the nm-range and high frequencies up to the THz-range, but the spin wave guiding means and magnetization mean, as well as excitation means and detection means still have spatial dimensions, which allow for the utilization of photolithographic processed during production.

The bandwidth of the excited spin wave can be determined by a bandwidth of the excitations means and/or the input radiofrequency signal.

The excitation means has a certain bandwidth, which allows the excitation of spin waves of a certain wavelength. The oscillating magnetic field is generated by the excitation means, and hence by the spatial current distribution in the excitation means.

A Fourier transformation of the spatial distribution of the oscillating magnetic field created by the spatial current distribution allows for the analysis of the wavelengths (or wavenumbers) which can be excited with the excitation means. However, only a certain band of wavelengths can be excited with the excitation means, which translates into a certain specific frequency bandwidth using the spin wave manifold.

For example, if the antenna is a stripline antenna, which is basically a single conducting wire with a rectangular cross section on top of the spin wave guiding means, then Fourier transform of the oscillating magnetic field of the antenna gives a measure for the available wavelength which can be excited with such an antenna. Such a stripline antenna cannot excite spin waves with a wavelength smaller than the width of the antenna. Hence, the bandwidth in terms of the wavelength is limited to the range between infinity and the width.

Hence, if the input signal has a first bandwidth and the excitation means allow only for the excitation of spin waves in a second bandwidth, then only spin waves in the overlap of both bandwidth can be excited. Hence, the input radiofrequency signal is filtered.

The bandwidth of the spin wave can be determined by a geometry of the spin wave guiding means.

The spin wave guiding means allow for the transport of certain spin wave modes, with a specific wavelength due to spatial limitations in the spin wave guiding means. I.e. the spin wave guiding means spatially confine the spin wave such that only certain spin wave modes can be excited, for example perpendicular standing spin wave modes or width modes.

Due to the spin wave manifold, the limitation to certain spin wave modes translate into a limited frequency bandwidth in which spin waves can be excited.

It is also possible that the magnetic material of the spin wave guiding means is structured, in particular periodically structured along the propagation direction of the spin waves. For example, a so-called magnonic crystal allows or vice versa forbids the propagation of spin waves of a certain wavelength which matches the periodic boundary conditions in the magnonic crystal. A periodic structure can be a periodic groove pattern in the spin wave guiding means, or a periodic pattern of the thickness or the width of the spin wave guiding means or a periodic modulation of the saturation modulation or periodic metallization of the spin wave guiding means.

The magnonic crystals create a set of band gaps in which the propagation of spin waves with a certain wavelength is forbidden. The regions in between the forbidden bands can be considered as so called passbands. In other words, the periodic structures only allow the propagation of certain wavelength in the spin wave guiding means, which translates into a limited frequency bandwidth.

The bandwidth of the spin wave can be determined by a periodicity of the static magnetic field provided by the magnetization means.

A periodicity can also be provided by the static magnetic field. For example, the static magnetic field can be periodically varied along the length axis of the spin wave guiding means. In this way an artificial magnonic crystal can be formed, which also results in a limited frequency bandwidth.

The bandwidth of the output radiofrequency signal can be determined by a bandwidth of the detection means.

As for the excitation means, the detection means are only able to detect spin waves, if the spin wave wavelength corresponds to a detectable wavelength. The detectable wavelengths are given by the Fourier transform of the spatial current distribution in the detection means. For example, if the detection means has the size of the spin wave wavelength, then there is no current induced in the detection means.

The frequency of the input radiofrequency signal can be between 0.5GHz and 80GHz, preferably between 10GHz and 30GHz, preferably 26GHz.

With this, the process can be applied to communication systems of the fifth generation. For example, the n77 band of a 5G device corresponds to 3.7 GHz, whereas the n258 band corresponds to a central frequency of 26 GHz.

The power of the input radiofrequency signal is between -90dBm +10dBm, preferably between - 90dBm and +30 dBm.

This allows the filtering of strong radiofrequency signals which is necessary in the case of bad wireless connection. However, this also allows for the filtering of weak signals in the case of weak signal reception.

The insertion loss at the frequency of the input radiofrequency signal can be less than 40dB, preferably less than 3dB.

The insertion loss is the ratio of the energy of the output radiofrequency signal in the detection means compared to the energy of the input radiofrequency put into the excitation means. The smaller the ratio, the higher the insertion loss.

In general, the larger the volume of the spin wave guiding means interacting with the input radiofrequency signal, the smaller the insertion loss. The insertion loss can further be adjusted by the length of the excitation means, the spacing between the excitation and detection means, the thickness of the spin wave guiding means, the width of the spin wave guiding means, and the number of a plurality of spin wave guiding means along the excitation means.

A small insertion loss is preferred, as the energy consumption can be reduced.

The bandwidth of the output radiofrequency signal can be below 200MHz, preferably below 50MHz, more preferably below 10MHz.

The bandwidth can be regarded for example as the full-width-half-maximum (FWHM) value of the output radiofrequency signal around the center frequency of the signal. Such small bandwidths allow for the filtering of radiofrequency signals which are used in modern fifth generation mobile communication systems for example in n77 and n256 bands.

According to a further aspect of the invention, a filtering device for filtering input radiofrequency signals is suggested, which comprises excitations means, magnetization means, spin wave guiding means and detection means, wherein the magnetization means is configured for magnetizing a spin wave guiding means using a static magnetic field, wherein the excitation means is configured for generating an input radiofrequency signal that excites spin waves in the spin wave guiding means, wherein the spin wave guiding means is configured for guiding the spin waves from the excitation means to the detection means, wherein the detection means is configured for detecting the spin waves in the spin wave guiding means an for transforming the detected signal into an output radiofrequency signal, wherein the input radiofrequency signal is filtered by the excitation means and/or by detection means and/or by the spin wave guiding means and/or by the magnetization means.

The excitation means and/or the detection means is a stripline antenna or a meander antenna, preferably a meander antenna with more than 3 periods, more preferably with more than 10 periods, where the periodicity is between 10nm and 100µm, for example 10µm.

A stripline antenna consists of a single conductive strip, typically with a rectangular cross section. The stripline antenna is usually straight and runs along the antenna length. The stripline antenna is configured to be electrically connected to an input radiofrequency signal source, such that the input radiofrequency signal can be transmitted through the stripline antenna grounded on another side.

A meander antenna consists of a plurality of conductive strips which are configured to transport electrical current in opposite current directions. A meander antenna can also be a single conductive strip that is periodically folded or bent into a serpentine pattern, resembling a series of connected "U" or "V" shapes. The meander antenna increases the effective length of the antenna within a defined physical space. Further the periodicity of the antenna translates over the spatial current distribution into a bandwidth of the excitation means.

The design of the antenna thereby matches to the impedance of the excitation means and/or of the detection means, to avoid microwave reflections and microwave losses. For example the antenna has an impedance of 30Ω or 50Ω or 100Ω.

The periodicity of the meander antenna is the spatial separation between the two closest bends or strips with the same current direction. The periodicity of the meander antenna determines the center wavelength of the bandwidth.

The bandwidth of the meander antenna in the wavelength space is defined by the number of periods of the meander antenna. The more periods, the smaller the bandwidth of the excitation means. The bandwidth in the frequency space can then be determined from the bandwidth in the wavelength space by the spin wave manifold in the spin wave guiding means.

Preferably, the meander antenna is positioned on the spin wave guiding means in such a way, that the magnetic component of the oscillating magnetic field is perpendicular to the static magnetization of the spin wave guiding means. The direction of the spin wave propagation is governed by the orientation of the excitation means, basically by the direction perpendicular to the length axis of the antenna.

The conductive strips building the meander antenna can have a width between 5nm and 100µm, for example 200nm, preferably between 450nm and 1µm, and/or a thickness between 1nm to 20µm, for example 15µm, preferably between 10nm and 100nm.

The periodicity of the meander antenna allows to select the wavelength or the wavenumber with the highest excitation efficiency. For example a periodicity of the meander antenna of 400nm, results in a wavelength of 400nm.

A proper selection of the wavelength by a given static magnetic field and a certain frequency is important for the reduction of the insertion loss.

The spin wave guiding means can comprise at least one spin wave waveguide, wherein preferably the magnetization of the spin wave waveguide is aligned along the width axis of the spin wave waveguide.

A spin wave waveguide is typically a magnetic strip with a specific length and a rectangular or trapezoidal cross section. The magnetization of the stripline typically aligns with the longest axis, here the length axis, when no external static magnetic field is applied.

However, in the invention the magnetization is aligned along the width axis of the spin wave waveguide. Such an alignment can either be achieved by anisotropies in the magnetic spin wave waveguide or by a static magnetic field which is aligned along the width axis of the magnetic spin wave waveguide.

The orientation of the magnetization along the width axis allows the spin wave propagation along the length direction in the so-called Damon-Eshbach geometry, where the wavevector of the spin wave is perpendicular to the magnetization. The advantage of this geometry is the high group velocities of spin waves which allow for a fast data processing, the long spin wave decay lengths as well as the improved efficiency of the spin wave excitation and detection means, since both the in-plane and out-of-plane components of the generated alternative magnetic field exert a torque on the excitation of spin waves and act constructively for spin waves propagating in one direction.

The spin wave waveguide can for example comprise or consist of yttrium iron garnet, permalloy or cobalt iron boron, or the like.

The width of the spin wave waveguide can be between 1 nm and 10µm, preferably between 450nm and 1µm.

The spin wave waveguides themselves are magnetic resonators, where the width determines the occurrence of standing spin wave modes along the width axis of the spin wave waveguide.

Also along the length direction the spin wave waveguide acts as a resonator. I.e. the length of the spin wave waveguide can be tuned to a natural multiple of the spin wave wavelength.

The width and the thickness also contribute to the bandwidth of the filtering.

The thickness of the spin wave waveguide can be between 1 nm and 5µm.

The spin wave waveguides also build resonators along the thickness axis, and thus the occurrence of perpendicular standing spin waves. The thickness also contributes to the bandwidth of the filtering.

However, the thickness solves another technical problem. If the amplitude of the input radiofrequency signal is larger than a certain critical threshold, non-linear effects such as magnon scattering will occur. The consequences of magnon scattering include energy and momentum transfer to the magnetic material, as well as modifications in the spin wave manifold and relaxation processes, influencing the overall magnetic dynamics and transport properties of the material. Magnon scattering thus limits the transport of angular momentum trough the spin wave guiding means. In other words, magnon scattering increases the insertion loss of the filter.

In some embodiments the spin wave waveguide comprises magnetic multilayers, where the magnetic layers of the magnetic multilayers are exchange decoupled via non-magnetic layers, for example by Ruthenium. By varying the thickness of non-magnetic layer the degree of exchange decoupling between the magnetic layers can be optimized.

By limiting the thickness or the width of the spin wave waveguide, the magnon scattering processes can be suppressed or prohibited in the magnetic system, which decreases the insertion loss of the filter for high input powers. The reduction in the size of the spin wave waveguide leads to the quantization of the magnonic modes in it, to the dilution of the magnon dispersion spectrum and to the suppression of the multimagnon scattering. The reduced size of the spin wave waveguides results in an increase in the maximum operational microwave power of the devices.

The length of the spin wave waveguide can be smaller than 10-times the spin wave decay length, preferably smaller than the spin wave decay length and/or the length of the spin wave waveguide can be between 200nm and 500µm.

The spin waves decay after a decay time to 1/e of their initial amplitude, where the decay time is given by the magnetic damping. The product of the spin wave decay time and the group velocity yields the spin waves decay length after which the spin waves decay to 1/e of their initial amplitude. Thus, the spin wave waveguide can be limited to the spin wave decay length.

In SAW filters, Bragg mirrors are utilized outside the filters to keep the acoustic wave confined. However, using spin waves no Bragg mirrors are required, as the spin wave is automatically confined to the magnetic system of the spin wave guiding means.

The length of the spin wave waveguides outside the excitation means and detection means can be specially chosen to provide resonance conditions for the reflection of spin waves towards the detection means.

It is also possible that the distance between the excitation means and the detection means is chosen to provide resonance conditions for the excitation and detection of the spin wave.

The spin wave guiding means can comprise a plurality of spin wave waveguides, wherein the spin wave waveguides are aligned in parallel to each other, wherein the distance between two adjacent spin wave waveguides is between 100nm and 100µm, preferably 400nm.

The plurality of spin wave waveguides increases the magnetic volume with which the input radiofrequency signal in the excitation means can interact. The input radiofrequency signal in the excitation means excites the spin waves simultaneously in the plurality of spin wave guiding means under the neglection of retardation effects. In this way the insertion loss can be reduced as the interaction volume is increased. It is also possible to transport a higher energy through the plurality of the spin wave waveguides, as each spin wave waveguide contributes to the output signal equally and the multimagnon scattering is suppressed in each individual waveguide.

However, the spin wave waveguides need a separation as otherwise the plurality of spin wave waveguides interact with each other mutually and eventually resemble a magnetic film which is periodically structured along the width direction. It is preferred that the spin wave waveguides can be controlled individually, thus a separation distance between 100nm and 100µm, preferably 400nm is introduced.

The magnetization means can comprise at least one magnetization strip, wherein the magnetization strip is aligned parallel to the spin wave waveguide.

A magnetization strip is typically a magnetic strip with a specific length and a rectangular cross section. The magnetic strip thereby provides an external magnetic field to the spin wave waveguides. In other words, the magnetization strip magnetizes the spin wave waveguide.

To align the magnetization of the spin wave waveguide, the magnetization strip preferably provides a static magnetic field at the position of the spin wave waveguide in the order of the magnitude of the saturation magnetization of the spin wave waveguide.

In other embodiments the magnetic field strength is sufficient high to saturate the magnetization of the spin wave waveguide into the field direction.

The magnetization means can comprise or consist of neodymium-iron-boron, iron-platinum, samarium, or the like. The required magnetization orientation of the magnetization means can be achieved by an initial application of large magnetic fields above 1T to the magnetization means. An additional magnetic anisotropy can be induced in the magnetization means for example by deposition of the magnetic material in the presence of magnetic field. In other word, the orientation of the magnetization can for example be determined during a production process.

Every spin wave waveguide can be arranged between two magnetization strips.

The magnetic field lines around a single magnetic strip are closed loops. The magnetic field strength thus strongly depends on the distance to the magnetic strip, which might introduce an inhomogeneous external static magnetic field to the spin wave waveguide. In such an inhomogeneous static magnetic field the spin wave manifold has a strong spatial dependence, which leads to magnon scarrering along the length of the spin wave waveguide.

To avoid such a magnon scattering, the spin wave waveguide can be arranged between two magnetic strips. In such a configuration the static magnetic field which is homogeneous, as the magnetic field lines join together.

The magnetization strip can magnetize the spin wave waveguide along its width direction.

In this way, a spin wave propagation in the Damon-Eshbach-Geometry is enabled, which allows for a fast transport of angular momentum, see above.

The magnetization strip can comprises more than two separated submagnets, preferably where the submagnets are nanomagnets.

The separated submagnets provide a global magnetic field to the spin wave waveguide, which is locally altered by the magnetization of the submagnet.

For example, every magnetic strip can comprise an array of hard magnet NdFeB nanomagnets. The nanomagnets together provide the static magnetic field. The magnetic field strength can be adjusted by the shape and size of the nanomagnets, for example the thickness, the width and the periodic spacing between the nanomagnets, as well as the distance to the spin wave waveguides.

Additionally the nanomagnets introduce, when separated in equal distances, a periodicity to the static magnetic field. In this way an artificial magnonic crystal can be formed in the spin wave waveguide.

Preferably, the size of the nanomagnets is in the order of the size of the width and/or height of the spin wave waveguide. It is also possible that the nanomagnets have a diameter which refers to width of the magnetization strip or the thickness of the magnetization strip.

The length of the magnetization means can be larger than the length of the spin wave guiding means.

This allows for a uniform magnetization of the spin wave guiding means, as magnetic stray fields at the end of the spin wave guiding means separated from the spin wave guiding means.

The static magnetic field created by the magnetization means at the position of the spin wave guiding means can be higher than 100mT, preferably higher than 500mT, more preferably higher than 1T.

The static magnetic fields allow for an alignment of the magnetization of the spin wave waveguides. The strength of the static magnetic field furthermore determines the frequency space of the spin wave manifold. For example yttrium iron garnet has a saturation magnetization of 175mT, permalloy has a saturation magnetisation of around 900mT, iron has a saturation magnetization of 1000mT and cobalt iron boron has a saturation magnetization of 1800T.

If the static magnetic field exceeds the saturation magnetization, the magnetization of the spin wave waveguide is aligned along the direction of the external field. However, it is not necessary to provide a magnetic field which exceeds the saturation magnetization, as the saturation magnetization itself can be decreased by demagnetization effects or anisotropies, such that the magnetization of the spin wave waveguide can be aligned along the external magnetic field well before saturation magnetization field strength.

### Brief description of the drawings

The present disclosure will be more readily appreciated by reference to the following detailed description when being considered in connection with the accompanying drawings in which:
- Figure 1A, B, C: is a schematic view of a first embodiment of a filtering device for filtering radiofrequency signals;
- Figure 2A, B: is a schematic view of a second embodiment of a filtering device for filtering radiofrequency signals;
- Figure 3: is a schematic view of a third embodiment of a filtering device for filtering radiofrequency signals;
- Figure 4: is a schematic view of a fourth embodiment of a filtering device for filtering radiofrequency signals;
- Figure 5: is a schematic view of a fifth embodiment of a filtering device for filtering radiofrequency signals;
- Figure 6: is a schematic view of an embodiment of the excitation means and detection means;
- Figure 7: is a schematic view of a process for filtering radiofrequency signals; and
- Figure 8: is a schematic view of a magnetization means which is aligned on the spin wave guiding means.

### Detailed description of preferred embodiments

In the following, the invention will be explained in more detail with reference to the accompanying figures. In the Figures, like elements are denoted by identical reference numerals and repeated description thereof may be omitted in order to avoid redundancies.

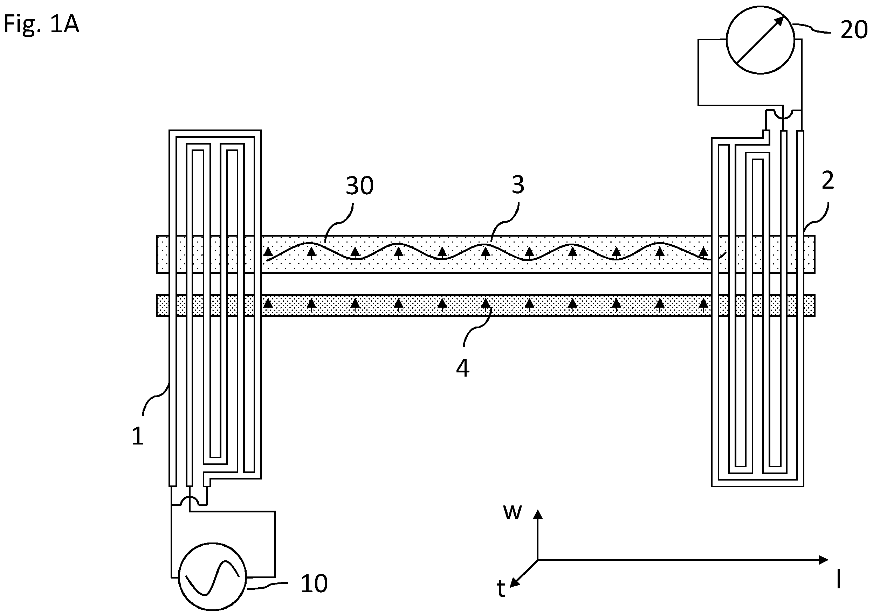

Fig.1A shows a schematic view of a filtering device for filtering input radiofrequency signals 10, according to the invention. The filtering device comprises excitation means 1 and detection means 2. Furthermore the filtering device comprises spin wave guiding means 3 and magnetization means 4.

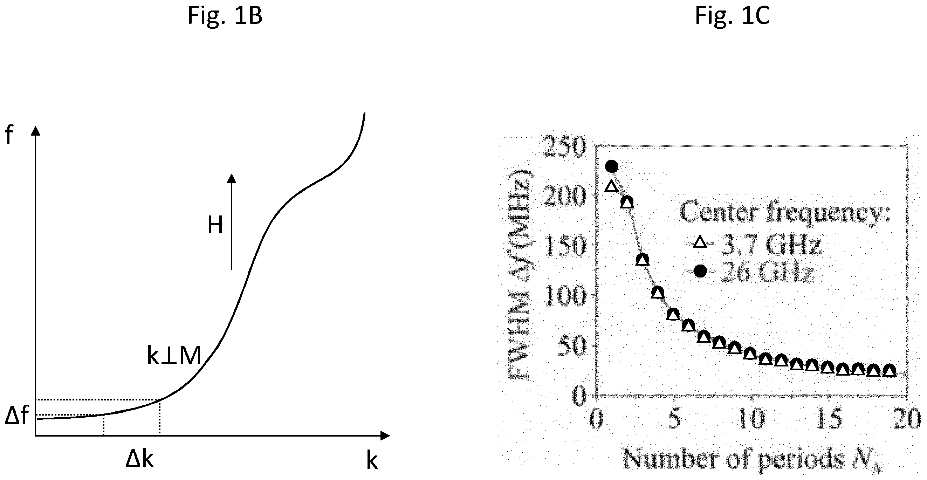

The magnetization means 4 are arranged in the length direction I and provide a static magnetic field to the spin wave guiding means 3 in the width direction w. The magnetization of the spin wave guiding means 3 thus aligns its magnetization substantially along the direction of the static magnetic field provided by the magnetization means 4. As shown in Fig. 1 both the arrows in the magnetization means 4 and the spin wave guiding means 3 are aligned in parallel.

The spin wave guiding means 3 provide a spin wave manifold, which describes the manifold of all available spin waves in the spin wave guiding means, depending on the spatial configuration of the spin wave guiding means, as well as the material properties, such as the spin wave exchange stiffness and the saturation magnetization. Only the spin waves available in the spin wave manifold can be excited.

The excitation means 1 provide an excitation mechanism to the spin wave guiding means 3. The excitation means 1 is fed with an input radiofrequency signal 10, which creates an oscillation magnetic field. The oscillating magnetic field deflects the static magnetization of the spin wave guiding means 3 periodically, which creates a spin wave 30 in the spin wave guiding means 3, only if the frequency of the oscillating magnetic field corresponds to an available spin wave 30 in the spin wave manifold.

The spin waves 30 propagate along the spin wave guiding means 3 from the excitation means 1 to the detection means 2. Below the detection means 2, the detection means 2 detect an oscillating magnetic field in the spin wave guiding means 3 by electromagnetic induction and create a output radiofrequency signal 20. Hence, the spin wave transports the input radiofrequency signal 10 from the excitation means 1 to the detection means 2.

The input radiofrequency signal 10 is filtered by the excitation means 1 and/or by detection means 2 and/or by the spin wave guiding means 3 and/or by the magnetization means 4 as shown below.

In Fig. 1A the excitation means 1 comprises a meander antenna with a meandering structure. The meander antenna consists of a single strip width a rectangular cross section which is bent periodically. In particular the meander antenna of Fig. 1 comprises two periods. The width of the strip, the number of periods and the separation between the different bends allow for the determination of a certain bandwidth of the excitation means 2.

The width of the antenna strips in Fig. 1A is in the range between 250nm to 2µm, preferably between 450nm and 1µm and their thickness is in the range from 1nm top 1µm, preferably between 10nm to 100nm. The periodicity of the antenna is between 10nm and 10µm, which results an width of the excitation means 2 of about 40nm to 40µm in Fig. 1A.

The antennas can be fabricated using photolithography, magnetron sputtering, and lift-off methods and can comprise or consist of gold and/or copper. Copper is preferred due to the decreased costs.

Note that the antennas of the excitation means 1 and the detection means 2 can be arranged upside-down. In this way, the antennas (including their contact pads) can be arranged closely together.

The current distribution in the meandering structure determines the wavelengths which can be excited with the meandering antenna.

Fig. 1B shows a spin wave manifold for the first width mode for the spin waves that propagate perpendicular to the magnetization M in the Damon-Eshbach configuration. The spin wave manifold connects the wavenumber of the spin wave with the frequency of the spin wave. The spin wave manifold is shifted to higher frequencies, if the static magnetic field is increased. Also the decrease of the width of the spin wave guiding means 3 shift the spin wave manifold to higher frequencies. For more details, we refer to Kalinikos and Slavin, "Theory of dipole-exchange spin wave spectrum for ferromagnetic films with mixed exchange boundary conditions", J. Phys. C: Solid State Phys. 19 (1986) 7013.

It is clear from Fig. 1B that a bandwidth in the wavenumber space (and thus in the wavelength space) translates to a bandwidth in the frequency space.

Fig. 1C shows the simulated bandwidth of a meander antenna for center frequencies of 3.7GHz and 26GHz. The bandwidth is hereby determined as the full width half maximum value of the peak intensity. The bandwidth decreases with increasing number of periods from a bandwidth of approximately 250MHz for a single period to a bandwidth of 25MHz for 20 periods.

The spin wave guiding means in Fig. 1A comprises a single spin wave waveguide 3', which comprises a magnetic material. The spin wave waveguide 3' has a rectangular cross section with a thickness in the range from 10nm up to 15µm and a width between 1nm and 10µm, preferably between 450nm and 1µm. The length of the spin wave waveguide 3' can be between 200nm and 500µm. The magnetization of the magnetic material is aligned along the width direction. For example the spin wave waveguide 3' can comprise or consist of yttrium iron garnet, permalloy or cobalt iron boron.

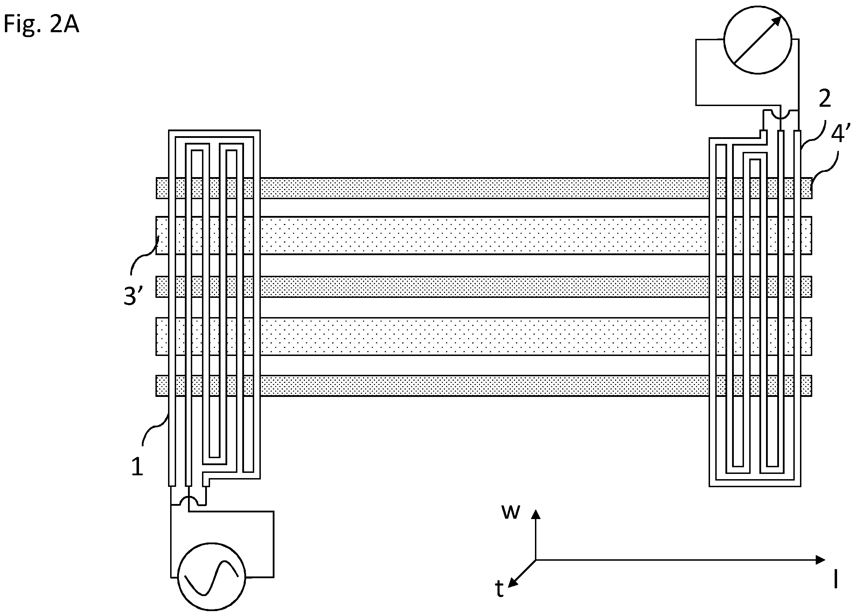

Fig. 2A shows a second embodiment of the filter device. The filter device comprises a plurality of magnetization means 4 and a plurality of spin wave guiding means 3. In particular, each of the spin wave waveguides 3' is aligned in parallel to each other, where the distance between the spin wave waveguides is between 100nm and 100µm preferably 400nm or 450nm and each spin wave waveguide is arranged between two magnetization strips 4'. Furthermore, the magnetization strips 4' are aligned in parallel to each other. All magnetization strips 4' and spin wave waveguides 3' are thus aligned in parallel to each other.

The plurality of spin wave waveguides 3' allows to decrease the insertion loss, as the interaction volume between the excitation means 1 and the magnetic system of the spin wave guiding means 3 is increased. Furthermore, the plurality of magnetic strips 4' increases the homogeneity of the provided static magnetic field.

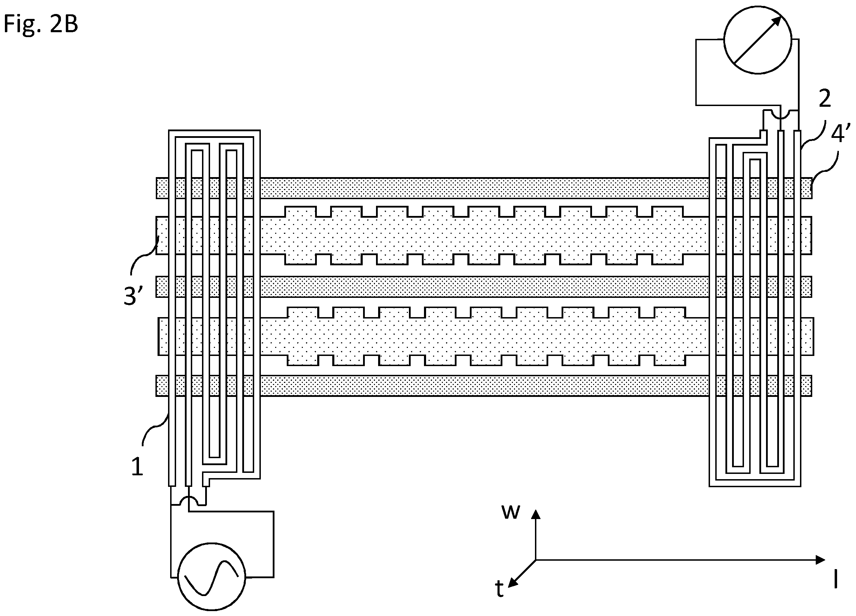

Fig. 2B shows another embodiment of the filter device, where the spin wave waveguides 3' have a periodically modulated width. The periodic modulation of the width creates a periodic modulation of the boundary conditions due to the variation of the demagnetizing field, i.e. the internal magnetic field in the spin wave waveguides 3'. The periodic modulation creates bands with allowed and forbidden bands in the spin wave manifold. For example, if the spin wave wavelength corresponds to the periodicity of the width modulation along the propagation direction, this spin wave is allowed to propagate. Otherwise the transmission is strongly reduced. The periodicity of the width modulation thus determines a bandwidth of the spin wave guiding means 3.

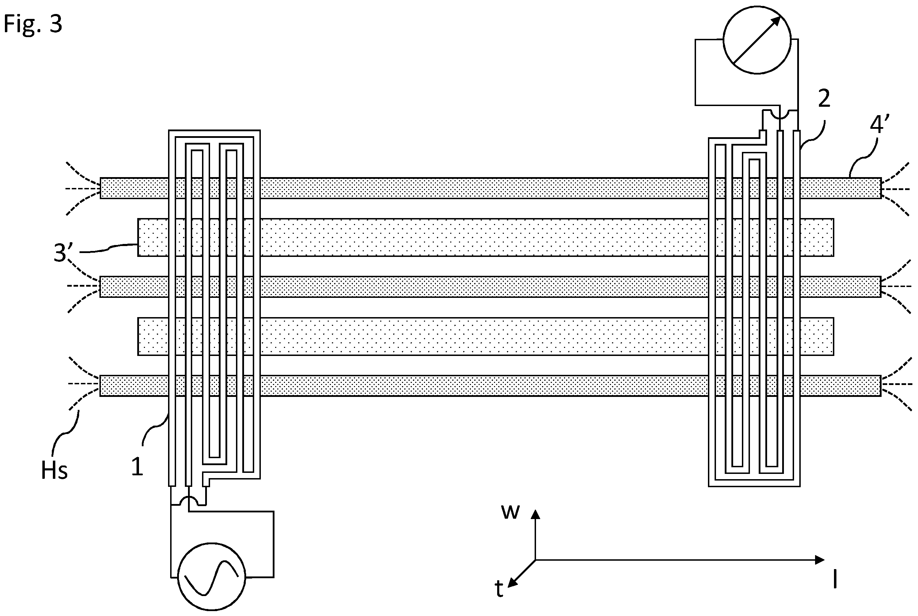

Fig. 3 shows a third embodiment of the filter device. The length of the magnetization strips 4' is larger than the length of the spin wave waveguides 3'. Is this way it is possible to separate to magnetic stray fields Hs at the ends of the magnetic strips 4' from the spin wave waveguides 3'. Hence, the homogeneity of the static magnetic field at the spin wave waveguides 3' is improved.

For example, in Fig. 3 the spin wave waveguides consist of YIG with a width of 80nm with a separation of 400nm. The length of the spin wave waveguides is in the rage between 10nm to 500µm.

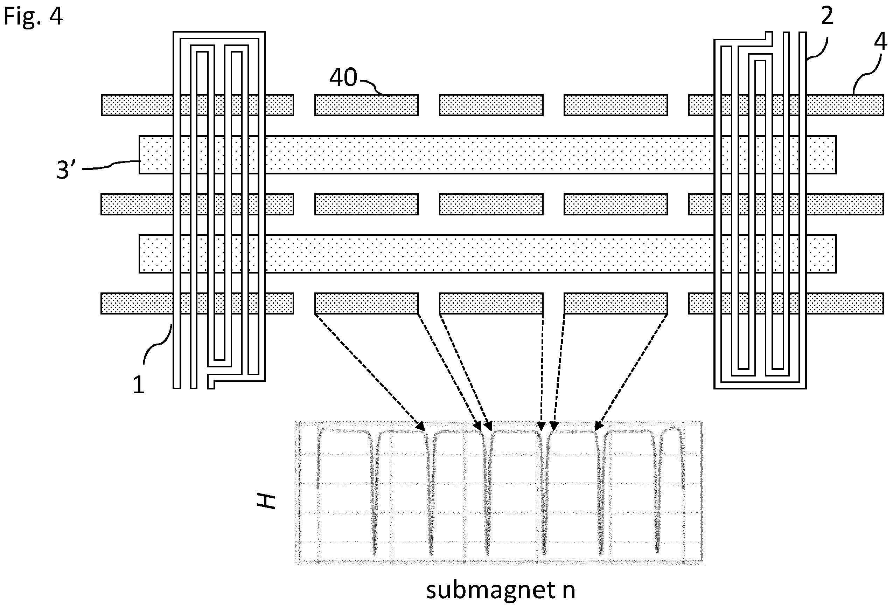

Fig. 4 shows another embodiment of the filter device. The magnetization means 4 comprise a plurality of submagnets 40. The submagnets 40 introduce a periodicity of the static magnetic field H, which leads to the formation of allowed and forbidden bands in the spin wave manifold, as shown in the inset. For example, only spin waves 30 with a wavelength of the periodicity of the static magnetic field H can propagate through such a periodically aligned magnetization.

The separation of the submagnets 40 can for example be 100nm, whereas the length of each submagnet 40 is 1500nm, where the thickness of each submagnet 40 is 400nm.

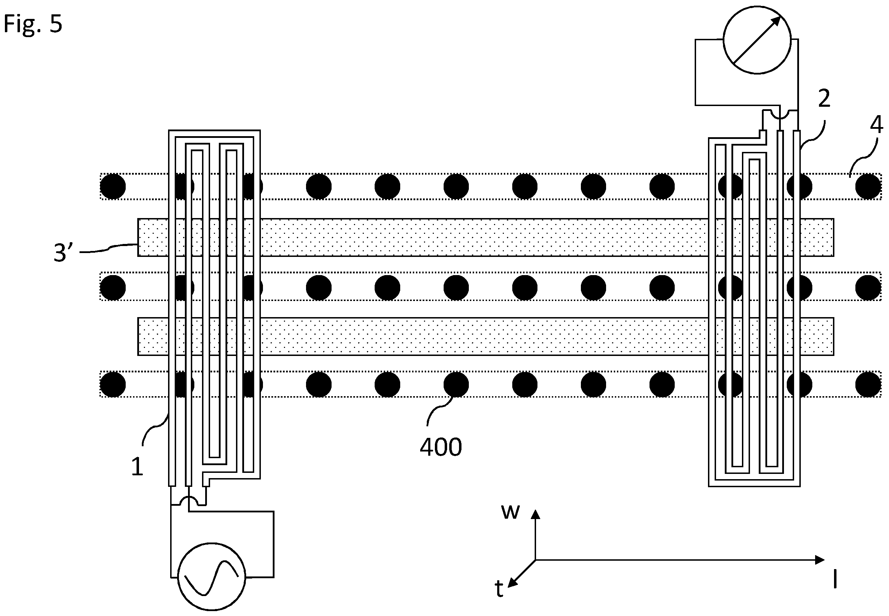

Fig. 5 shows a fifth embodiment of the filtering device, where the submagnets 40 are nanomagnets 400. In particular, the nanomagnets 400 have a separation along the length axis of the magnetization means 4. This also provides a period magnetic field to the spin wave waveguides 3'.

For example, an array of neodym iron boron nanomagnets can be used to apply the required static magnetic field to the spin wave waveguides 3'. The material can be deposited using the sputtering, for example on silicon and gallium gadolinium garnets on Si and GGG substrates in the thickness range from 50nm up to 1 µm. An interlayer material can also be arranged to achieve an in-plane magnetization of the nanomagnets, i.e. a magnetization in the plane of the spin wave waveguides 3'.

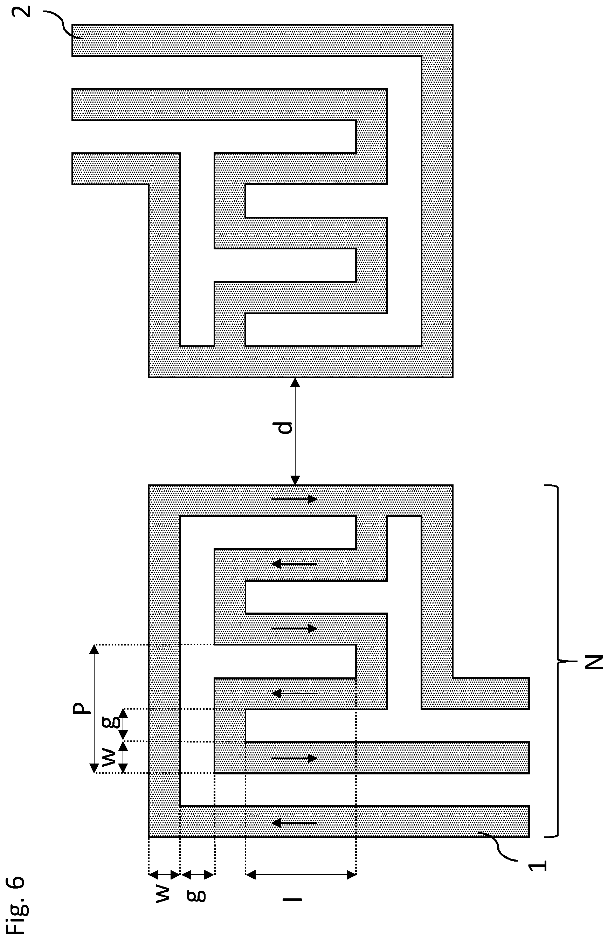

Fig. 6 shows a possible embodiment of the excitation means 1 and detection means 2. Both the excitation means 1 and detection means 2 are meander antennas. The width w of the conductive strip is for example 450nm. The gap g between two conductive wires can be 450nm. The periodicity P is the distance between conductive strips with the same current direction, and thus 1,8µm. The length I of the meander antenna can be for example 5µm but depends on the number of spin wave waveguides and the gap between the spin wave waveguides (not shown). The excitation means 1 comprises three periods, Na=3. The distance d between the excitation means 1 and the detection means 2 can be a multiple N of the spin wave wavelength λ.

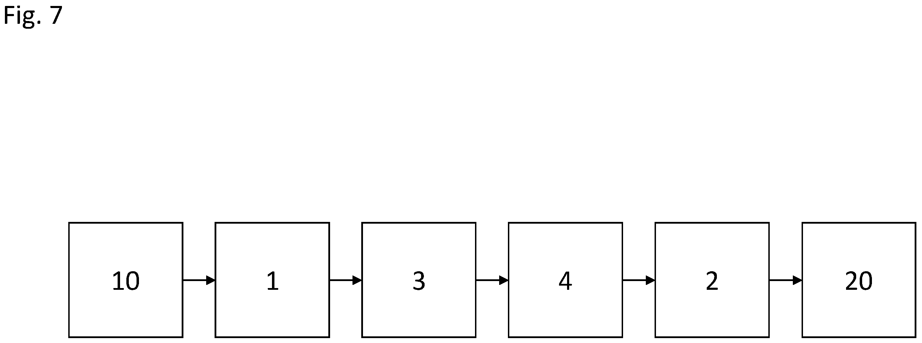

Fig. 7 shows a process to a corresponding process for filtering input radiofrequency signals 10 with the filter device shown in Figs. 1 to 5.

In a first step the input radiofrequency signal 10 is delivered to the excitation means 1.

The excitation means 2 generate in a second step an oscillation magnetic field which excites spin waves 30 in the spin wave guiding means 3. The excitation means 2 can provide oscillating magnetic fields with a certain wavenumber, which determines the most efficient wavenumber to be excited in the spin wave guiding means 3. The bandwidth of the excitation means 1 is governed for example by the periodicity and shape of the excitation means 2.

The spin wave guiding means 3 itself can comprise a periodically structure, which generates allowed and forbidden spin wave bands in the spin wave manifold. Thus the bandwidth of the spin wave 30 in the spin wave guiding means 3 is determined by the geometry of the spin wave guiding means 3. The spin wave guiding means 3 transports the spin wave from the excitation means 1 to the detection means 2.

The spin wave guiding means 3 is magnetized by the magnetization means 4 with a static magnetic field. The magnetization means 4 can provide a periodically modulated magnetic field to the spin wave guiding means 3, such that allowed or forbidden spin wave are generated in the spin wave manifold.

The detection means 2 detect the oscillating magnetic field generated by the spin wave 30 in the spin wave guiding means 3. The detection means 2 imprint the bandwidth of the detection means 2 on the output radiofrequency signal 20 which is induced by the spin wave into the detection means 2.

The bandwidth can be adjusted with each means 1, 2, 3, 4 individually. For example, the spin wave 30 can propagate through a homogeneously magnetized spin wave waveguide 3' with a uniform width, but the excitation antenna 1 excites spin waves 30 with a first bandwidth and the detection antenna 2 detects the spin waves 30 with a second bandwidth. The input radio frequency signal 10 is thus filtered with a combination of the first and second bandwidth.

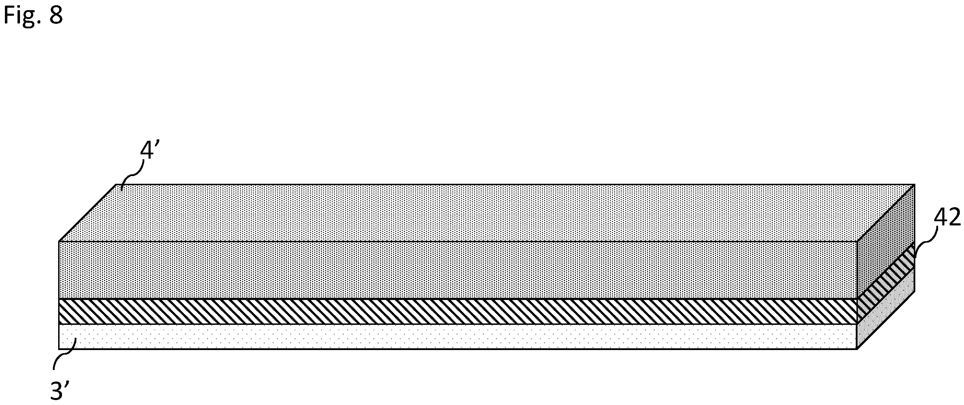

The magnetization strip 4' can be in direct contact to the spin wave waveguide or a (de)-coupling layer 42 might be arranged between the magnetization strip 4' and the spin wave waveguide 3', where the (de)coupling layer does not provide significant exchange coupling. The latter alternative is illustrated in Fig. 8.

The (de)-coupling layer 42 might be any non-magnetic material. If the decoupling layer is non-conducting the generation of eddy currents can be decreased. The magnetization strip 4' can be any hard magnetic material. If the magnetization strip 4' is non-conducting the generating of eddy currents is decreased. Alternatively, the magnetization strip 4' can be laminated onto the spin wave waveguide. In particular, a multilayer of magnetic layers and non-conducting layers can be arranged on the spin wave waveguide to reduce eddy currents. Depending on the spin wave mode, also gaps can be structured in the magnetization strip in order to reduce eddy currents. The magnetization strip 4' can be arrange above or below the spin wave waveguide 3'. In particular, the magnetization strip 4' and the spin wave waveguide 3' can have the same geometry. Then both the magnetization strip 4' and the spin wave waveguide 3' can be structured in a single production step.

It will be obvious for a person skilled in the art that these embodiments and items only depict examples of a plurality of possibilities. Hence, the embodiments shown here should not be understood to form a limitation of these features and configurations. Any possible combination and configuration of the described features can be chosen according to the scope of the invention.

### List of reference numerals

- 1: excitation means
- 10: input radiofrequency signal
- 2: detection means
- 20: output radiofrequency signal
- 3: spin wave guiding means
- 3': spin wave waveguide
- 30: spin wave
- 4: magnetization means
- 4': magnetization strip
- 40: submagnet
- 400: nanomagnet
- 42: magnetic (de)-multilayer

## Claims

1. Process for filtering input radiofrequency signals (10),
wherein a spin wave guiding means (3) is magnetized using a static magnetic field of a magnetization means (4),
wherein a spin wave (30) is excited in the spin wave guiding means (3) by excitation means (1) using an input radiofrequency signal (10),
wherein the spin waves (30) are guided by the spin wave guiding means (3) from the excitations means (1) to detection means (2),
wherein the spin wave (30) is detected in the spin wave guiding means (3) by the detection means (2) and transformed into an output radiofrequency signal (20),
**characterized in that**
the input radiofrequency signal (10) is filtered by the excitation means (1) and/or by detection means (2) and/or by the spin wave guiding means (3) and/or by the magnetization means (4).

2. Process according to claim 1, **characterized in that**
- the bandwidth of the excited spin wave (30) is determined by a bandwidth of the excitations means (1) and/or the input radiofrequency signal (10)
- the bandwidth of the spin wave (30) is determined by a geometry of the spin wave guiding means (4) and/or
- the bandwidth of the spin wave (30) is determined by a periodicity of the static magnetic field provided by the magnetization means(4) and/or
- the bandwidth of the output radiofrequency signal (20) is determined by a bandwidth of the detection means (3).

3. Process according to any of the preceding claims, **characterized in that** the frequency of the input radiofrequency signal (10) is between 0.5GHz and 80GHz, preferably between 10GHz and 30GHz, preferably 26GHz and/or
the power of the input radiofrequency signal (10) is between -90dBm to +10dBm, preferably between -90dBm and +30dBm

4. Process according to any of the preceding claims, **characterized in that** the insertion loss at the frequency of the input radiofrequency signal (10) is less than 40dB, preferably less than 3dB.

5. Process according to any of the preceding claims, **characterized in that** the bandwidth of the output frequency signal (20) is below 200MHz, preferably below 50MHz.

6. Filtering device for filtering input radiofrequency signals (10), comprising excitations means (1), magnetization means (4), spin wave guiding means (3) and detection means (2)
wherein the magnetization means (4) is configured for magnetizing a spin wave guiding means (3) using a static magnetic field,
wherein the excitation means (1) is configured for generating an input radiofrequency signal (10) that excites spin waves (30) in the spin wave guiding means (3),
wherein the spin wave guiding means (3) is configured for guiding the spin waves (30) from the excitation means (1) to the detection means (2),
wherein the detection means (2) is configured for detecting the spin waves (30) in the spin wave guiding means (3) an for transforming the detected signal into an output radiofrequency signal (20),
**characterized in that**
the input radiofrequency signal (10) is filtered by the excitation means (1) and/or by detection means (2) and/or by the spin wave guiding means (3) and/or by the magnetization means (4).

7. Filtering device according to claim 6, **characterized in that** the excitation means (1) and/or the detection means (2) is a stripline antenna or a meander antenna, preferably a meander antenna with more than 3 periods, more preferably with more than 10 periods, where the periodicity is between 10nm and 100µm.

8. Filtering device according to claim 7, **characterized in that** the conductive strips building the meander antenna can have a width between 5nm and 100µm, preferably between 450nm and 1µm, and/or a thickness in the range from 1nm to 20µm, preferably between 10nm and 100nm.

9. Filtering device according to any of claims 6 to 8, **characterized in that** the spin wave guiding means (3) comprises at least one spin wave waveguide (3'), wherein preferably the magnetization of the spin wave waveguide (3') is aligned along the width axis of the spin wave waveguide (3).

10. Filtering device according to claim 9, **characterized in that**
the width of the spin wave waveguide (3') is between 1nm and 10µm, preferably between 450nm and 1µm and/or
the thickness of the spin wave waveguide (3') is between 1nm and 10µm and/or
the length of the spin wave waveguide (3') is smaller than 10-times the spin wave decay length, preferably smaller than the spin wave decay length and/or the length of the spin wave waveguide (3) is between 200nm to 500µm.

11. Filtering device according to any of claims 9 or 10, **characterized in that** the spin wave guiding means (3) comprises a plurality of spin wave waveguides (3'), wherein the spin wave waveguides (3) are aligned in parallel to each other, wherein the distance between two adjacent spin wave waveguides (3') is between 100nm and 100µm, preferably 400nm or 450nm

12. Filtering device according to any of claims 10 to 11, **characterized in that** the magnetization means (4) comprises at least one magnetization strip (4'), wherein the magnetization strip (4') is aligned parallel to the spin wave waveguide (3'),
preferably wherein every spin wave waveguide (3') is arranged between two magnetization strips (4'),
preferably where the magnetization strip (4') magnetizes the spin wave waveguide along its width direction.

13. Filtering device according to claim 12, **characterized in that** the magnetization strip (4') comprises more than two separated submagnets (40'), preferably where the submagnets are nanomagnets.

14. Filtering device according to any of claims 7 to 13, **characterized in that** the length of the magnetization means (4) is larger than the length of the spin wave guiding means (3).

15. Filtering device according to any of claims 7 to 14, **characterized in that** the static magnetic field created by the magnetization means (4) at the position of the spin wave guiding means (3) is higher than 100mT, preferably higher than 500mT, more preferably higher than 1T.

16. Filtering device according to any of claims 7 to 11, **characterized in that** the magnetization means (4) is arranged on top or below the spin wave waveguide (3), where optionally an (de)-coupling layer is arranged between the magnetization means (4) and the spin wave guiding means (3).

17. Filtering device according to any of claims 7 to 16, **characterized in that**
the excitation means (1) consist or comprise heavy metals, wherein the input radiofrequency signal generate spin orbit torques, wherein to spin orbit torques excite spin waves (30) in the spin wave guiding means
and/or
the detection means (2) consist or comprise heavy metals, wherein the spin wave (30) in the spin wave guiding means (3) generate a spin current, wherein the spin current is transformed into an output radiofrequency signal (20) in the detection means (2)
